# EUROPEAN PATENT SPECIFICATION

(11) **EP 3 388 853 B1**
(45) Date of publication and mention of the grant of the patent: **30.12.2020**
(21) Application number: 16873176.8
(22) Date of filing: 12.05.2016
(51) Int. Cl.: G01R 33/46, G01R 33/485, G01R 33/483

(54) **METHOD FOR SUPPRESSING WATER SIGNAL AND REINFORCING METABOLITE SIGNAL BY ADJUSTING CENTRAL FREQUENCY AND RECEPTION BANDWIDTH OF EXCITATION SIGNAL BAND IN MRS IMAGE TECHNIQUE**
VERFAHREN ZUR UNTERDRÜCKUNG EINES WASSERSIGNALS UND VERSTÄRKUNG EINES METABOLITSIGNALS DURCH EINSTELLEN DER ZENTRALEN FREQUENZ UND EMPFANGSBANDBREITE EINES ANREGUNGSSIGNALBANDES IN EINEM MRS-BILDVERFAHREN
PROCÉDÉ DE SUPPRESSION DU SIGNAL D'EAU ET DE RENFORCEMENT DE SIGNAL DE MÉTABOLITE PAR AJUSTEMENT DE FRÉQUENCE CENTRALE ET DE BANDE PASSANTE DE RÉCEPTION DE BANDE DE SIGNAL D'EXCITATION DANS UNE TECHNIQUE D'IMAGE PAR SRM

(30) Priority: 11.12.2015 KR 20150176793
(43) Date of publication of application: 17.10.2018
(73) Proprietor: Gil Medical Center, Incheon 21565 (KR); Gachon University of Industry-Academic Cooperation Foundation, Seongnam-si, Gyeonggi-do 13120 (KR)
(72) Inventor: CHOI, Sang Han, Incheon 21561 (KR); CHUNG, Jun Young, Incheon 21561 (KR)
(74) Representative: Müller Schupfner & Partner Patent- und Rechtsanwaltspartnerschaft mbB
(86) International application number: PCT/KR2016/004961
(87) International publication number: WO 2017/099310

(56) References cited:
- KR-B1- 101 560 463
- KR-B1- 101 568 214
- US-A1- 2001 003 423
- US-A1- 2011 221 439
- US-A1- 2014 213 887
- FRAHM J ET AL: "LOCALIZED HIGH-RESOLUTION PROTON NMR SPECTROSCOPY USING STIMULATED ECHOES: INITIAL APPLICATIONS TO HUMAN BRAIN IN VIVO", MAGNETIC RESONANCE IN MEDICINE, JOHN WILEY & SONS, INC, US, vol. 9, no. 1, January 1989 (1989-01), pages 79-93, XP000004945, ISSN: 0740-3194
- GEEN H ET AL: "Band-selective pulses without phase distortion. A simulated annealing approach", JOURNAL OF MAGNETIC RESONANCE, ACADEMIC PRESS, LONDON, GB, vol. 85, no. 3, December 1989 (1989-12), pages 620-627, XP023959063, ISSN: 0022-2364, DOI: 10.1016/0022-2364(89)90254-0 [retrieved on 1989-12-01]
- BUUAN LAM ET AL: "Direct 1H NMR spectroscopy of dissolved organic matter in natural waters", ANALYST, vol. 133, no. 2, 2008, pages 263-269, XP055601454, UK ISSN: 0003-2654, DOI: 10.1039/B713457F

## Description

### [Technical Field]

The present invention relates to a method for suppressing a water signal and reinforcing a metabolite signal by adjusting a central frequency of an excitation signal band and a receiver bandwidth in a magnetic resonance spectroscopy (MRS) image technology, and more specifically, to a method for suppressing a water signal and reinforcing a metabolite signal by adjusting only a central frequency of an excitation signal and a receiver bandwidth in an MRS image technology without applying an additional gradient magnetic field or additional RF signal.

### [Background Art]

Since an MRI image technique implements images based on water signals, the water signals being received become very important information. However, in an MRS imaging technique used for analyzing materials of interest other than water *in vivo*, a water signal is not only of no value as chemical characterization information, but it also degrades the resolution of information of other materials of interest (*i.e*., necessary information), and thus the water signal must be removed as much as possible while maximizing material signals.

Examples of methods commonly used to remove a water signal include the chemical shift selective imaging sequence (CHESS) method, water suppression enhanced through T₁ effects (WET) method, and spectral suppression method.

CHESS is a method for unilaterally suppressing the signal of a specific frequency using an RF pulse.

Since the RF pulses being used have only a specific frequency of the tissue to be measured, they can selectively excite only water through an RF pulse and thereby remove a water signal.

WET is a method for eliminating imperfections in suppressing the water signal caused by a residual water signal by effectively removing the residual water signal in the existing CHESS method. Although the WET method is more effective than the CHESS method in suppressing the water signal, the WET method has problems in that it requires more time and causes a specific absorption rate (SAR) because it requires 3 RF additions. The spectral suppression method employs inversion recovery. Although the method is effective in suppressing a water signal, it also has a disadvantage in that RF must be applied between two 180 degree RF pulses after an excitation signal, thus increasing the echo time (TE).

Even when the conventional methods for suppressing a water signal described above are applied, the center frequency of the excitation signal is generally set to the resonant frequency of water (4.7 ppm). Accordingly, although a water signal is suppressed by applying any of the above methods for suppressing a water signal, there are still problems in that the water signal is still influential and also that signals of considerable bands above the resonant frequency of the water are received together when the signal frequencies of the materials of interest are all below the resonant frequency of water (4.7 ppm).

Methods for reinforcing the signal of a material generally include a method of modifying the MRS imaging parameters and a method of post-processing the acquired data. The method for reinforcing the signal of a material by modifying the MRS imaging parameters includes increasing the number of imaging repeats or increasing the unit size of the imaging area, but these methods have the disadvantages of increasing the imaging time and reducing the spatial resolution of the acquired data, respectively. The method for reinforcing the signal of a material by post-processing of the acquired data includes a method to use an apodization filter, and this method has the disadvantage of reducing the frequency resolution of acquired data.

### [Prior Art]

International Patent Publication No. WO2013-155209 A1

Geen H. et al., "Band-Selective Pulses without Phase Distortion. A Simulated Annealing Approach", Journal of Magnetic Resonance 85, 620-627 (1989), which describes the design of shaped pulses for selective excitation experiments in high-resolution NMR.

### [Disclosure]

### [Technical Problem]

An object of the present invention is to provide a method for suppressing a water signal and reinforcing a metabolite signal by adjusting only a central frequency of an excitation signal and a receiver bandwidth in an MRS imaging technology without applying an additional gradient magnetic field or additional RF signal.

### [Technical Solution]

To achieve the above object, the present invention provides a method of generating a magnetic resonance spectroscopy (MRS) image of a material of interest which has a resonant frequency smaller than the resonant frequency of water, the method comprising suppressing a water signal and reinforcing a metabolite signal by adjusting a central frequency of an excitation signal and a receiver bandwidth, wherein the method comprises: applying the size of the receiver bandwidth so as to be the same as a difference between the resonant frequency of water and the central frequency and applying the excitation signal adjusted so as to have a central frequency which is smaller than the resonant frequency of water, wherein the central frequency is a resonant frequency of a particular metabolite of interest.

The central frequency of an excitation signal is smaller than 4.7 ppm and the receiver bandwidth is the same as the difference between the resonant frequency of water and the central frequency.

The MRS image technique may be applied to the analysis of a material of interest having a signal frequency smaller than the resonant frequency of the water.

The method for suppressing a water signal and reinforcing a metabolite signal may be one that can be applied to ¹H MRS.

The MRS image technique may be one which may be applied to the analysis of a material of interest in any one material group among the material groups comprised by the combination of the following 8 materials of interest:
*N*-acetyl-L-aspartic acid (NAA: C₆H₉NO₅);
choline chloride (Cho: C₅H₁₄ClNO);
creatine hydroxide (Cr: C₄H₉N₃O₂);
L-glutamate (Glu: C₅H₁₀NNaO₅);
myo-inositol (ml: C₆H₁₂O₆);
DL-lactic acid (Lac: C₃H₆O₃);
gamma-amino butyric acid (GABA: C₄H₉NO₂); and
glutamine (Gln: C₅H₁₀N₂O₃).

### [Advantageous Effects of the Invention]]

According to the present invention, at least the following effects can be obtained.
1. The method for suppressing a water signal and reinforcing a metabolite signal of the present invention does not require the application of an additional gradient magnetic field or additional RF signal, and thus, the MRS process can be performed easily and conveniently even with MRS sequences which are conventionally used. As a result, the problem that the specific absorption rate (SAR) (*i.e*., an evaluation index for the amount of energy absorption *in vivo*) becomes poor (high) can be completely resolved, and additionally, the problem that scan time (TR) or echo time (TE) is extended due to the suppression of a water signal can be resolved.
2. The method for suppressing a water signal and reinforcing a metabolite signal of the present invention does not include steps relating to post data processing or repeated imaging, and thus, metabolite signals can be reinforced without increasing the time for imaging or reducing the frequency resolution of acquisition data.

### [Brief Description of Drawings]]

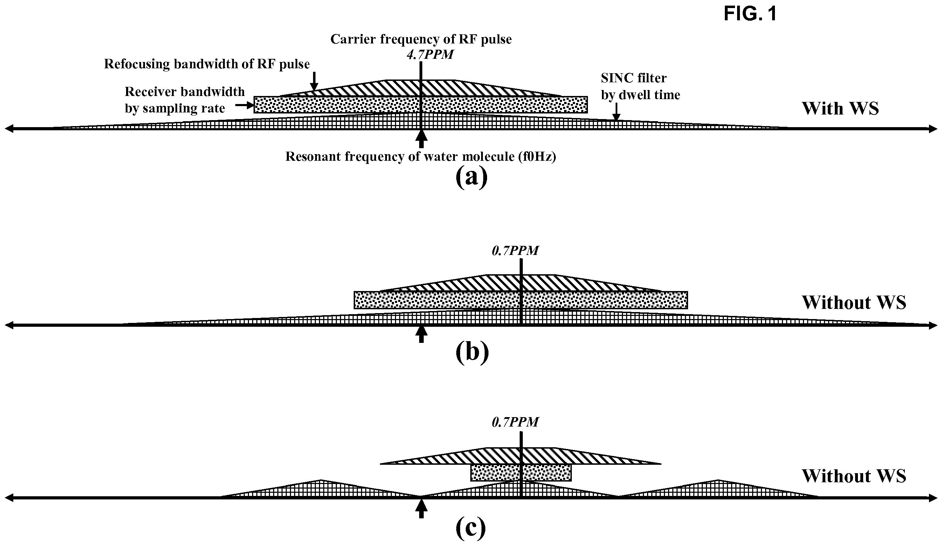

FIG. 1 and Table 1 show drawings for comparison between the prior art and the present invention, in which FIG. 1(a) shows a drawing with regard to an excitation signal and a receiver bandwidth according to the prior art, and FIG. 1(b) and FIG. 1(c) show drawings with regard to excitation signals and a receiver bandwidths according to the present invention. FIG. 1(b) shows a drawing with regard to a method for modifying only the excitation signal frequency values, and FIG. 1(c) shows a drawing with regard to a method for modifying the excitation signal frequency values as well as the receiver bandwidth. Table 1 shows the values of exemplary variables that can be performed for each method.

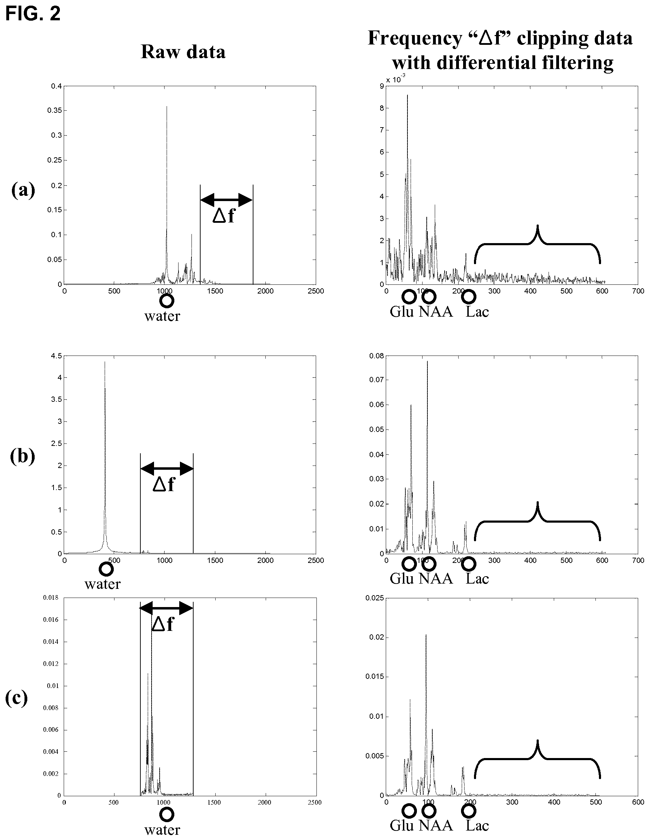

FIG. 2 shows drawings for comparison between the prior art and the present invention, in which FIG. 2(a) shows a drawing with regard to an example of the results of MRS analysis performed according to the prior art technology as a method for suppressing a water signal where the existing WET and spectrum suppression are applied together, and FIG. 2(b) and FIG. 2(c) show drawings with regard to examples of the results of MRS analysis performed by the methods for suppressing a water signal and reinforcing a metabolite signal according to FIG. 1(b) and FIG. 1(c), respectively (drawings on the left: data of entire spectrum, drawings on the right: data of spectrum regions of interest).

### [DETAILED DESCRIPTION OF THE INVENTION]

Hereinafter, the present invention will be described in more detail with reference to the accompanying drawings.

In a magnetic field environment, the resonant frequency of a particular material is proportional to the intensity of the magnetic field and is proportional to the rotational magnetic constant of the reference material. In the case of proton MRS, the reference material is tetramethylsilane (TMS) and the difference in resonant frequency between TMS and a material of interest can be expressed in Hz or part per million (ppm).

In a case where units of ppm are used instead of Hz, the resonant frequency of TMS in ppm is always 0 ppm and the resonant frequency of water in ppm is always 4.7 ppm, regardless of whether the main magnetic field in the proton MRS changes to 1 T, 1.5 T, 3 T, or 7 T. Accordingly, in a case where units of ppm are used, the difference in the resonant frequency between hydrogen and water is always 4.7 ppm, regardless of the strength of the main magnetic field.

Meanwhile, when the main magnetic field is 1 T, 1.5 T, 3 T, or 7 T, the resonant frequencies of TMS and water in units of MHz are as follows.

When the main magnetic field is 1 T, the resonant frequency of TMS is about 42.6 MHz and the resonant frequency of water is smaller than that of TMS by about 200 Hz (*i.e*., 42.6 × 4.7).

When the main magnetic field is 1.5 T, the resonant frequency of TMS is about 64 MHz (*i.e*., 42.6 × 1.5) and the resonant frequency of water is smaller than that of TMS by about 300 Hz *(i.e.,* 42.6 × 4.7 × 1.5).

When the main magnetic field is 3 T, the resonant frequency of TMS is about 128 MHz (*i.e*., 42.6 × 3) and the resonant frequency of water is smaller than that of TMS by about 600 Hz *(i.e.,* 42.6 × 4.7 × 3).

When the main magnetic field is 7 T, the resonant frequency of TMS is about 300 MHz (*i.e*., 42.6 × 7) and the resonant frequency of water is smaller than that of TMS by about 1,400 Hz (*i.e*., 42.6 × 4.7 × 7).

The present invention relates to a method for suppressing a water signal and reinforcing a metabolite signal by adjusting only a central frequency of an excitation signal and a receiver bandwidth in an MRS imaging technique without applying an additional gradient magnetic field or additional RF signal.

FIG. 1 shows drawings for comparison between the prior art and the present invention, in which FIG. 1(a) shows a drawing with regard to an excitation signal and a receiver bandwidth according to the prior art, and FIG. 1(b) and FIG. 1(c) show drawings with regard to excitation signals and a receiver bandwidths according to the present invention.

As illustrated in FIG. 1(a), the excitation signal band applied to the MRS imaging technique according to the prior art generally has a central frequency of 4.7 ppm, which corresponds to the resonant frequency of water, and has a bandwidth greater than about 9.0 ppm.

According to the prior art, the resonant frequency of water (4.7 ppm) is included in the excitation signal band, and thus, a water signal without value as information in chemical characterization may be included in the receiver bandwidth.

Accordingly, methods for suppressing a water signal, such as the chemical shift selective imaging sequence (CHESS) method, water suppression enhanced through T₁ effects (WET) method, spectral suppression method, *etc*., are used in the prior art for the removal of the water signal.

However, according to the methods for suppressing the water signal of the prior art, it is required that an additional gradient magnetic field, additional RF signal, *etc.* be applied, and thus the process cannot avoid being complex and time-consuming. Additionally, there is a limitation on the complete exclusion of the effect of the water signal because these methods cannot fundamentally block the excitation of water molecules themselves. Additionally, there is a disadvantage in terms of signal-to-noise ratio (SNR) because unnecessary signal bandwidth of considerable width are received in addition to the signal bandwidth of the materials of interest.

In the MRS imaging technique where the method for suppressing a water signal and reinforcing a metabolite signal according to the present invention is applied, an excitation signal adjusted to have a central frequency smaller than that of the resonant frequency of the water is applied (setting condition 1).

Since the resonant frequency of water is 4.7 ppm, an excitation signal having a central frequency of less than 4.7 ppm is applied in the present invention. For example, as illustrated in FIG. 1(a), an excitation signal having a central frequency of 0.7 ppm may be applied. The central frequency of an excitation signal applied to the present invention need not be limited to 0.7 ppm, but it may be varied depending on the kind of materials of interest to be analyzed through the MRS technique. However, as described above, the central frequency of an excitation signal is set to a value smaller than the resonant frequency of water (*i.e*., 4.7 ppm).

Additionally, in the MRS imaging technique where the method for suppressing a water signal and reinforcing a metabolite signal according to the present invention is applied, a receiver bandwidth, which is adjusted so as to be the same as the difference between the resonant frequency of water and the central frequency of a preset excitation signal, is applied (setting condition 2).

For example, as illustrated in FIG. 1(c), when the preset central frequency of an excitation signal is preset to 0.7 ppm, the receiver bandwidth is adjusted to be the same as the difference (4.0 ppm) between the resonant frequency of water (4.7 ppm) and its central frequency (0.7 ppm). In particular, since the difference between the resonant frequency of water (4.7 ppm) and its central frequency (0.7 ppm) is 4.0 ppm, the receiver bandwidth is preset to the same value (*i.e*., 4.0 ppm).

The water signal may be suppressed or removed and the metabolite signal may be reinforced according to the central frequency values in setting condition 1. As the application of the central frequency of an excitation signal is changed from a water signal band to a metabolite signal band, the frequency band at which the excitation signal acts is also shifted. Accordingly, the size of the water signal decreases while the size of the metabolite signal is reinforced.

The signal size of a specific metabolite is determined by the difference between the central frequency of an excitation signal and the resonant frequency of the specific metabolite, and the signal size becomes greater as the difference becomes smaller.

In a case where setting conditions 1 and 2 are both satisfied, the water signal can be completely removed and the metabolite signal can be reinforced according to the values of the central frequency of an excitation signal. However, in the case of setting condition 2, there is a limitation on the range of the receiver bandwidth.

In the MRS spectrum, the actual water signal is received in the Gaussian or Lorentzian form within the band range including its resonant frequency (4.7 ppm). In such a receiver bandwidth, the actual water signal that can provide an actual effect is in the range of 0.5 ppm with respect to the resonant frequency (4.7 ppm) and its entire range is 1 ppm.

In consideration of this, in the present invention, the receiver bandwidth may be set in a condition to be more reinforced than setting condition 1 so that the actual effect of a water signal can be completely excluded. That is, the water signal may be further suppressed by applying the central frequency of an excitation signal at a value less than 0.7 ppm.

As illustrated in FIG. 1(c), according to the present invention, when the central frequency of an excitation signal is adjusted to meet setting condition 1 and the receiver bandwidth is adjusted to meet setting condition 2, the excitation signal may be adjusted to have the band within the range of 0 ppm (*i.e*., a state where the water signal is fundamentally removed) to 4.7 ppm (*i.e*., the resonant frequency of water).

According to such a method for suppressing a water signal and reinforcing a metabolite signal of the present invention, these objects can be accomplished by blocking the excitation of water molecules in the process of applying an excitation signal to an analyte.

Therefore, the effect of a water signal can be substantially and completely excluded, and additionally, the process can be simple and the processing time can be reduced because the application of an additional gradient magnetic field or additional RF signal, *etc.* is not necessary, unlike in the conventional techniques.

The MRS imaging technique, in which the method for suppressing a water signal and reinforcing a metabolite signal of the present invention is applied, can be effectively applied to the analysis of a material of interest having a signal frequency smaller than the resonant frequency of the water.

**[Table 1]**

| Magnetic Field 7T 300 MHz | Water Suppress -ion | Carrier Frequency of RF Pulse | Receiver Bandwidth (setting/ data) | Dwell Time (s) | Vector Size (setting/data) | Acquisition Time (ms) |
|---|---|---|---|---|---|---|
| (a) | Engaged | 0 Hz shifted from the resonant frequency of water molecules | 2,000 Hz/ 4,000 Hz | 1/4,000 | 1,024/2,048 | 512 |
| (b) | Not Engaged | 1,200 Hz shifted from the resonant frequency of water molecules | 2,000 Hz/ 4,000 Hz | 1/4,000 | 1,024/2,048 | 512 |
| (c) | Not Engaged | 1,200 Hz shifted from the resonant frequency of water molecules | 600 Hz/ 1,200 Hz | 1/1,200 | 256/512 | 427 |

For example, the method for suppressing a water signal and reinforcing a metabolite signal of the present invention can be applied to a ¹H MRS image technique. The ¹H MRS image technique is an MRS imaging technique which is used for the analysis of materials having protons in addition to water.

In a specific embodiment, the MRS imaging technique applied to the method for suppressing a water signal and reinforcing a metabolite signal of the present invention may be applied to the analysis of a material of interest in any one material group among the material groups comprised by the combination of the following 8 materials of interest:
*N*-acetyl-L-aspartic acid (NAA: C₆H₉NO₅);
choline chloride (Cho: C₅H₁₄ClNO);
creatine hydroxide (Cr: C₄H₉N₃O₂);
L-glutamate (Glu: C₅H₁₀NNaO₅);
myo-inositol (ml: C₆H₁₂O₆);
DL-lactic acid (Lac: C₃H₆O₃);
*gamma*-amino butyric acid (GABA: C₄H₉NO₂); and
glutamine (Gln: C₅H₁₀N₂O₃).

The above 8 materials commonly have one or more protons and also have a signal frequency in the range of 0 ppm to 4.7 ppm. When the MRS imaging technique is applied to these materials of interest, the excitation signal band of 4.7 ppm or higher is not necessary for the excitation of these materials, and thus the method for suppressing a water signal and reinforcing a metabolite signal of the present invention can be effectively applied thereto.

FIG. 2 shows drawings for comparison between the prior art and the present invention, in which FIG. 2(a) shows a drawing with regard to an example of the results of MRS analysis performed according to the prior art technology as a method for suppressing a water signal where the existing WET and spectrum suppression are applied together, and FIG. 2(b) and FIG. 2(c) show drawings with regard to examples of the results of MRS analysis performed by the methods for suppressing a water signal and reinforcing a metabolite signal according to the present invention.

With regard to the prior arts of FIG. 2(a), as the MRS parameters, the central frequency of the excitation signal was set to 4.7 ppm and the receiver bandwidth was set to about 7.0 ppm, whereas, with regard to the technique of FIG. 2(b) of the present invention, the center frequency of the excitation signal as the MRS parameter was set to 0.7 ppm, and with regard to the technique of FIG. 2(c) of the present invention, the receiver bandwidth was set to 4.0 ppm while simultaneously setting the center frequency of the excitation signal to 0.7 ppm.

Referring to FIG. 2(a), most of the noise in the band adjacent to the resonant frequency of water (4.7 ppm) was removed because the existing WET and spectrum suppression were applied together as a method for suppressing a water signal. However, it was confirmed that the reception sensitivity to the materials of interest (*e.g*., Lac, NAA) distant from the resonant frequency of the water was relatively low. Referring to FIG. 2(b), as a result of applying the method for suppressing a water signal according to the present invention, it was confirmed that the noise in the band adjacent to the resonant frequency of water (4.7 ppm) was removed and that the reception sensitivity to the materials of interest (*e.g*., Lac, NAA) having a resonant frequency of 0.7 ppm was significantly improved compared to the conventional ones. Referring to FIG. 2(c), it was confirmed that the water signal was completely removed along with the reinforcement of the signals of materials of interest.

## Claims

1. A method of generating a magnetic resonance spectroscopy (MRS) image of a material of interest, which has a resonant frequency smaller than the resonant frequency of water, the method comprising suppressing a water signal and reinforcing a metabolite signal by adjusting a central frequency of an excitation signal and a receiver bandwidth, wherein the method comprises: applying the size of the receiver bandwidth so as to be the same as a difference between the resonant frequency of water and the central frequency and applying the excitation signal adjusted so as to have a central frequency which is smaller than the resonant frequency of water, wherein the central frequency is a resonant frequency of a particular metabolite of interest.

2. The method of claim 1, wherein the method for suppressing a water signal and reinforcing a metabolite signal is applied to ¹H MRS.

3. The method of claim 1, wherein the material of interest comprises any one of the following 8 materials of interest:
*N*-acetyl-L-aspartic acid (NAA: C₆H₉NO₅);
choline chloride (Cho: C₅H₁₄ClNO);
creatine hydroxide (Cr: C₄H₉N₃O₂);
L-glutamate (Glu: C₅H₁₀NNaO₅);
myo-inositol (ml: C₆H₁₂O₆);
DL-lactic acid (Lac: C₃H₆O₃);
*gamma*-amino butyric acid (GABA: C₄H₉NO₂); and
glutamine (Gln: C₅H₁₀N₂O₃).

4. The method of claim 1, wherein the central frequency is smaller than 4.7 ppm.

## Patentansprüche

1. Verfahren zur Erzeugung eines Magnetresonanzspektroskopie(MRS)-Bilds eines Materials von Interesse, das eine Resonanzfrequenz niedriger als die Resonanzfrequenz von Wasser hat, wobei das Verfahren umfasst Unterdrücken eines Wassersignals und Verstärken eines Metabolitsignals durch Einstellen einer Mittenfrequenz eines Erregungssignals und einer Empfängerbandbreite,
wobei das Verfahren umfasst: Anwenden der Größe der Empfängerbandbreite derart, dass sie gleich einer Differenz zwischen der Resonanzfrequenz von Wasser und der Mittenfrequenz ist, und Anwenden des Erregungssignals derart angepasst, dass es eine Mittenfrequenz hat, die niedriger ist als die Resonanzfrequenz von Wasser, wobei die Mittenfrequenz eine Resonanzfrequenz eines bestimmten Metabolits von Interesse ist.

2. Verfahren nach Anspruch 1, wobei das Verfahren zur Unterdrückung eines Wassersignals und Verstärkung eines Metabolitsignals auf ¹H MRS angewendet wird.

3. Verfahren nach Anspruch 1, wobei das Material von Interesse ein beliebiges der folgenden 8 Materialien von Interesse enthält:
N-Acetyl-L-Asparaginsäure (NAA: C₆H₉NO₅);
Cholinchlorid (Cho: C₅H₁₄ClNO);
Kreatinhydroxid (Cr: C₄H₉N₃O₂);
L-Glutamat (Glu: C₅H₁₀NNaO₅);
Myo-Inositol (ml: C₆H₁₂O₆);
DL-Milchsäure (Lac: C₃H₆O₃);
Gamma-Aminobuttersäure (GABA: C₄H₉NO₂); und
Glutamin (Gln: C₅H₁₀N₂O₃).

4. Verfahren nach Anspruch 1, wobei die Mittenfrequenz kleiner als 4,7 ppm ist.

## Revendications

1. Procédé de génération d'une image par spectroscopie par résonance magnétique (SRM) d'une matière d'intérêt, qui a une fréquence de résonance inférieure à la fréquence de résonance de l'eau, le procédé comprenant :
supprimer un signal d'eau et
renforcer un signal de métabolite en ajustant une fréquence centrale d'un signal d'excitation et une largeur de bande de récepteur,
dans lequel le procédé comprend : appliquer la taille de la largeur de bande du receveur de manière à ce qu'elle soit la même qu'une différence entre la fréquence de résonance de l'eau et la fréquence centrale et appliquer le signal d'excitation ajusté de manière à avoir une fréquence centrale qui est inférieure à la fréquence de résonance de l'eau, la fréquence centrale étant une fréquence de résonance d'un métabolite particulier d'intérêt.

2. Procédé selon la revendication 1, dans lequel le procédé pour supprimer un signal d'eau et renforcer un signal de métabolite est appliqué à ¹H SRM.

3. Procédé selon la revendication 1, dans lequel la matière d'intérêt comprend l'une quelconque des 8 matières d'intérêt suivantes :
acide N-acétyl-L-aspartique (NAA : C₆H₉NO₅) ;
chlorure de choline (Cho : C₅H₁₄ClNO) ;
hydroxyde de créatine (Cr : C₄H₉N₃O₂) ;
L-glutamate (Glu : C₅H₁₀NNaO₅) ;
myo-inositol (mI : C₆H₁₂O₆) ;
Acide DL-lactique (Lac : C₃H₆O₃) ;
acide *gamma*-aminobutyrique (GABA : C₄H₉NO₂) ; et
glutamine (Gln : C₅H₁₀N₂O₃).

4. Procédé selon la revendication 1, dans lequel la fréquence centrale est inférieure à 4,7 ppm.
